# EUROPEAN PATENT APPLICATION

(11) **EP 4 539 099 A1**
(43) Date of publication of application: **16.04.2025**
(21) Application number: 24200573.4
(22) Date of filing: 16.09.2024
(51) Int. Cl.: H01L 21/02, H01L 21/32, H01L 21/3105

(54) **PROCESSING METHOD, METHOD OF MANUFACTURING SEMICONDUCTOR DEVICE, PROCESSING APPARATUS, AND PROGRAM**

(30) Priority: 22.09.2023 JP 2023159104
(71) Applicant: Kokusai Electric Corporation, Tokyo 101-0045 (JP)
(72) Inventor: MIYATA, Shoma, Toyama-shi, Toyama 939-2393 (JP); NAKATANI, Kimihiko, Toyama-shi, Toyama 939-2393 (JP); DEGAI, Motomu, Toyama-shi, Toyama 939-2393 (JP)
(74) Representative: Bardehle Pagenberg Partnerschaft mbB Patentanwälte Rechtsanwälte

(57) **Abstract**

There is provided a technique that includes: (a) forming a first film containing a first element and a second element on a surface of a first base by supplying a first film-forming agent to a substrate including the first base and a second base; (b) forming an inhibitor layer on the first film by supplying a modifying agent to the substrate and causing at least a portion of molecular structures of molecules constituting the modifying agent to be adsorbed on the first film; and (c) forming a second film containing the first element and the second element on a surface of the second base by supplying a second film-forming agent to the substrate with the inhibitor layer formed on the first film.

## Description

### CROSS-REFERENCE TO RELATED APPLICATION

This application is based upon and claims the benefit of priority from Japanese P atent Application No. 2023-159104, filed on September 22, 2023, the entire contents of which are incorporated herein by reference.

### TECHNICAL FIELD

The present disclosure relates to a processing method, a method of manufacturin g a semiconductor device, a processing apparatus, and a program.

### BACKGROUND

In the related art, as a process of manufacturing a semiconductor device, there is sometimes a process in which a film is selectively grown and formed on a specific surfac e among multiple types of surfaces made of different materials exposed on a substrate s urface (hereinafter referred to as a "selective growth" or a "selective film formation").

### SUMMARY

According to some embodiments of the present disclosure, there is provided a tec hnique of selectively forming a film on a desired surface with high precision.

According to some embodiments of the present disclosure, there is provided a tec hnique that includes: (a) forming a first film containing a first element and a second ele ment on a surface of a first base by supplying a first film-forming agent to a substrate in cluding the first base and a second base; (b) forming an inhibitor layer on the first film b y supplying a modifying agent to the substrate and causing at least a portion of molecula r structures of molecules constituting the modifying agent to be adsorbed on the first fil m; and (c) forming a second film containing the first element and the second element on a surface of the second base by supplying a second film-forming agent to the substrate w ith the inhibitor layer formed on the first film.

### BRIEF DESCRIPTION OF DRAWINGS

The accompanying drawings, which are incorporated in and constitute a part of t he specification, illustrate embodiments of the present disclosure.
FIG. 1 is a schematic configuration diagram of a vertical process furnace of a proc essing apparatus suitably used in some embodiments of the present disclosure, in which a portion of the process furnace is shown in a vertical cross-sectional view.
FIG. 2 is a schematic configuration diagram of the vertical process furnace of the processing apparatus suitably used in some embodiments of the present disclosure, in w hich a portion of the process furnace is shown in a cross-sectional view taken along line A-A of FIG. 1.
FIG. 3 is a schematic configuration diagram of a controller of a processing appara tus suitably used in some embodiments of the present disclosure, in which a control syst em of the controller is shown in a block diagram.

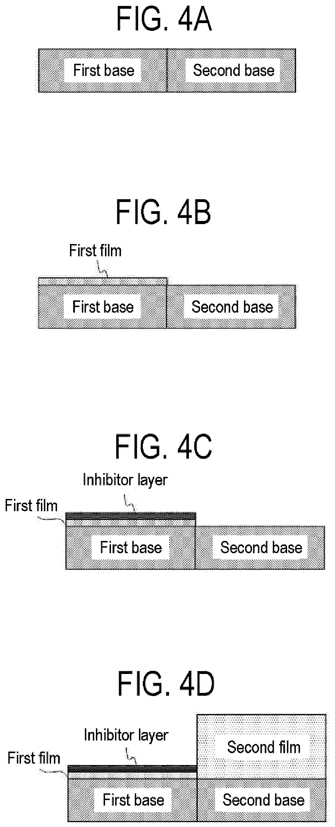

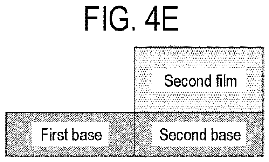

FIG. 4A is a cross-sectional schematic diagram illustrating a surface of a wafer in cluding a first base and a second base on a surface of the wafer. FIG. 4B is a schematic c ross-sectional diagram illustrating the surface of the wafer after selectively forming a fir st film on a surface of the first base, by performing Step A from a state of FIG. 4A. FIG. 4C is a schematic cross-sectional diagram illustrating the surface of the wafer after formi ng an inhibitor layer on a surface of the first film formed on the surface of the first base, by performing Step B from a state of FIG. 4B. FIG. 4D is a schematic cross-sectional dia gram illustrating the surface of the wafer after selectively forming a second film on a sur face of the second base, by performing Step C from a state of FIG. 4C. FIG. 4E is a sche matic cross-sectional diagram illustrating the surface of the wafer after removing the firs t film formed on the surface of the first base together with the inhibitor layer, by perfor ming Step D from a state of FIG. 4D.
FIGS. 5A to 5D are diagrams similar to FIGS. 4A to 4D, respectively. FIG. 5E is a schematic cross-sectional diagram illustrating the surface of the wafer after selectively f orming a third film on a surface of the second film formed on the surface of the second b ase, by performing Step E from a state of FIG. 5D. FIG. 5F is a schematic cross-sectional diagram illustrating the surface of the wafer after removing the first film formed on the s urface of the first base together with the inhibitor layer, by performing Step D from a sta te of FIG. 5E.

### DETAILED DESCRIPTION

### <Embodiments of Present Disclosure>

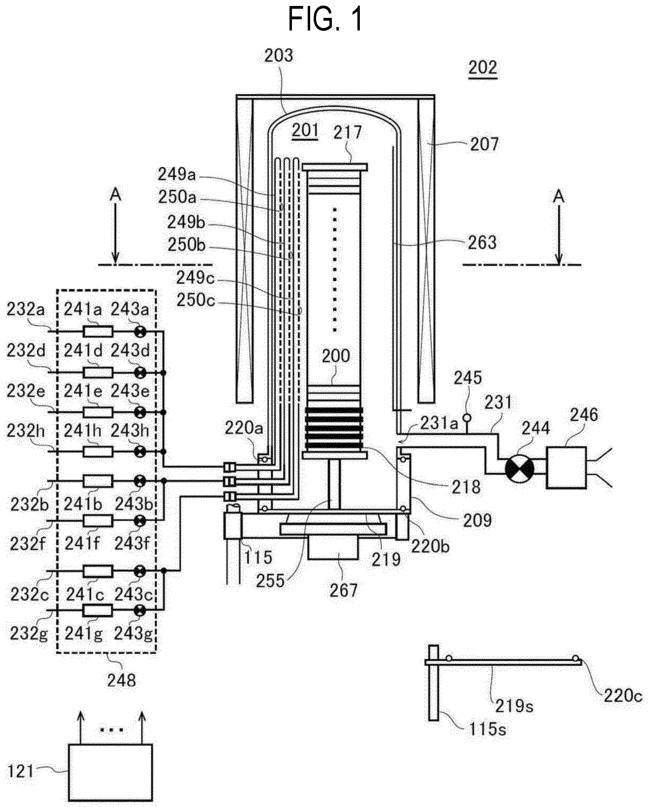

Hereinafter, some embodiments of the present disclosure will be described main ly with reference to FIGS. 1 to 3 and FIGS. 4A to 4E. The drawings used in the following description are schematic, and dimensional relationships, ratios, and the like of the resp ective components shown in the drawings may not match the actual ones. Further, dim ensional relationships, ratios, and the like of the respective components among plural dr awings may not match one another.

### (1) Configuration of Processing Apparatus (Processing System)

As illustrated in FIG. 1, a process furnace 202 of a processing apparatus includes a heater 207 serving as a temperature regulator (heating part). The heater 207 is forme d in a cylindrical shape and is mounted vertically by being supported by a holding plate. The heater 207 functions as an energy provider configured to provide energy to a gas, an d also functions as an activator (exciter) when the gas is thermally activated (excited).

A reaction tube 203 is arranged inside the heater 207 so as to be concentric with t he heater 207. The reaction tube 203 is made of, for example, a heat-resistant material such as quartz (SiO₂) or silicon carbide (SiC) and is formed in a cylinder shape with a clo sed upper end and an open lower end. A manifold 209 is arranged to be concentric with the reaction tube 203 under the reaction tube 203. The manifold 209 is made of, for exa mple, metal material such as stainless steel (SUS), and is formed in a cylindrical shape w ith open upper and lower ends. The upper end of the manifold 209 is configured to be e ngaged with the lower end of the reaction tube 203, thus supporting the reaction tube 2 03. An O-ring 220a is provided as a seal between the manifold 209 and the reaction tub e 203. The reaction tube 203 is vertically installed, similar to the heater 207. A process container (reaction container) mainly includes the reaction tube 203 and the manifold 2 09. A process chamber 201 is formed in a hollow cylindrical area of the process contain er. The process chamber 201 is configured to be capable of accommodating a wafer 200 serving as a substrate. The wafer 200 is processed inside the process chamber 201.

Nozzles 249a to 249c as first to third suppliers are installed in the process chamb er 201 to penetrate a sidewall of the manifold 209, respectively. The nozzles 249a to 24 9c are also referred to as first to third nozzles, respectively. The nozzles 249a to 249c ar e made of, for example, a heat-resistant material such as quartz or SiC. Gas supply pipe s 232a to 232c are connected to the nozzles 249a to 249c, respectively. The nozzles 249 a to 249c are different nozzles, respectively, and each of the nozzles 249a and 249c is ins talled adjacent to the nozzle 249b.

Mass flow controllers (MFCs) 241a to 241c serving as flow rate controllers (flow r ate control parts), and valves 243a to 243c serving as opening/closing valves, are install ed at the gas supply pipes 232a to 232c, respectively, sequentially from the upstream sid e of gas flow. Gas supply pipes 232d, 232e, and 232h are each connected to the gas supp ly pipe 232a at the downstream side of the valve 243a. Gas supply pipes 232f and 232g are connected to the gas supply pipes 232b and 232c at the downstream side of the valve s 243b and 243c, respectively. The gas supply pipes 232d to 232h are provided with MF Cs 241d to 241h and valves 243d to 243h, respectively, sequentially from the upstream si de of gas flow. The gas supply pipes 232a to 232h are made of, for example, a metal mat erial such as SUS.

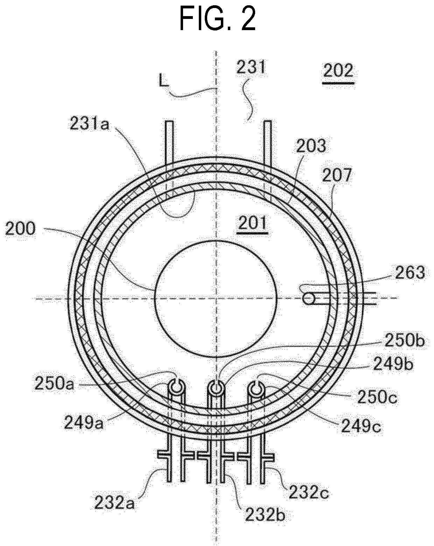

As illustrated in FIG. 2, the nozzles 249a to 249c are each arranged in an annular space (in a plane view) between an inner wall of the reaction tube 203 and the wafer 20 0 to extend upward from a lower side to an upper side of the inner wall of the reaction tu be 203, that is, along an arrangement direction of the wafers 200. In other words, the n ozzles 249a to 249c are each installed at a region horizontally surrounding a wafer arran gement region in which the wafers 200 are arranged at the lateral side of the wafer arra ngement region, along the wafer arrangement region. In a plane view, the nozzle 249b i s disposed to face an exhaust port 231a, which will be described later, on a straight line with a center of the wafer 200 loaded into the process chamber 201 being interposed bet ween the nozzle 249b and the exhaust port 231a. The nozzles 249a and 249c are dispose d to sandwich a straight line L passing through the nozzle 249b and a center of the exha ust port 231a from both sides along the inner wall of the reaction tube 203 (outer periph ery of the wafer 200). The straight line L is also a straight line passing through the nozzl e 249b and the center of the wafer 200. In other words, it may also be said that the nozz le 249c is installed at an opposite side of the nozzle 249a with the straight line L interpo sed therebetween. The nozzles 249a and 249c are arranged in line symmetry with the st raight line L as an axis of symmetry. Gas supply holes 250a to 250c configured to suppl y a gas are formed at side surfaces of the nozzles 249a to 249c, respectively. The gas sup ply holes 250a to 250c are each opened to oppose (face) the exhaust port 231a in a plane view, and is configured to be capable of supplying the gas toward the wafer 200. A plura lity of gas supply holes 250a to 250c are formed from the lower side to the upper side of the reaction tube 203.

Precursors, i.e., a first precursor, a second precursor, and a third precursor, are s upplied from the gas supply pipe 232a into the process chamber 201 via the MFC 241a, v alve 243a, and nozzle 249a. The first precursor is used as a first film-forming agent. Th e second precursor is used as a second film-forming agent. The third precursor is used a s a third film-forming agent.

Catalysts, i.e., a first catalyst, a second catalyst, and a third catalyst, are supplied f rom the gas supply pipe 232b into the process chamber 201 via the MFC 241b, valve 243 b, and nozzle 249b. The first catalyst is used as a first film-forming agent. The second c atalyst is used as a second film-forming agent. The third catalyst is used as a third film-f orming agent.

Oxidizing agents, i.e., a first oxidizing agent, a second oxidizing agent, and a third oxidizing agent, are supplied from the gas supply pipe 232c into the process chamber 20 1 via the MFC 241c, valve 243c, and nozzle 249c. The first oxidizing agent is used as a fir st film-forming agent. The second oxidizing agent is used as a second film-forming agen t. The third oxidizing agent is used as a third film-forming agent.

A modifying agent is supplied from the gas supply pipe 232d into the process cha mber 201 via the MFC 241b, valve 243d, gas supply pipe 232a, and nozzle 249a.

An etching agent is supplied from the gas supply pipe 232h into the process cham ber 201 via the MFC 241h, valve 243h, gas supply pipe 232a, and nozzle 249a.

An inert gas is supplied from the gas supply pipes 232e to 232g into the process c hamber 201 via the MFCs 241e to 241g, valves 243e to 243g, gas supply pipes 232a to 23 2c, and nozzles 249a to 249c. The inert gas acts as a purge gas, a carrier gas, a dilution g as, and the like.

A precursor supply system (first precursor supply system, second precursor suppl y system, and third precursor supply system) mainly includes the gas supply pipe 232a, MFC 241a, and valve 243a. A catalyst supply system (first catalyst supply system, secon d catalyst supply system, and third catalyst supply system) mainly includes the gas suppl y pipe 232b, MFC 241b, and valve 243b. An oxidizing agent supply system (first oxidizin g agent supply system, second oxidizing agent supply system, and third oxidizing agent s upply system) mainly includes the gas supply pipe 232c, MFC 241c, and valve 243c. The precursor supply system (first precursor supply system, second precursor supply system , and third precursor supply system), the catalyst supply system (first catalyst supply sys tem, second catalyst supply system, and third catalyst supply system), and the oxidizing agent supply system (first oxidizing agent supply system, second oxidizing agent supply system, and third oxidizing agent supply system) are also referred to as film-forming age nt supply systems (first film-forming agent supply system, second film-forming agent su pply system, and third film-forming agent supply system). A modifying agent supply sys tem mainly includes the gas supply pipe 232d, MFC 241b, and valve 243d. An etching a gent supply system mainly includes the gas supply pipe 232h, MFC 241h, and valve 243 h. An inert gas supply system mainly includes the gas supply pipes 232e to 232g, MFCs 241e to 241g, and valves 243e to 243g.

One or the entirety of the various supply systems described above may be constit uted as an integrated supply system 248 where the valves 243a to 243h, MFCs 241a to 2 41h, and the like are integrated. The integrated supply system 248 is connected to each of the gas supply pipes 232a to 232h, and is configured such that operations of supplyin g various substances (various gases) into the gas supply pipes 232a to 232h such as the o pening/closing operations of the valves 243a to 243h and the flow rate regulating operat ions by the MFCs 241a to 241h are controlled by a controller 121, which will be described later. The integrated supply system 248 is constituted as an integral-type or detachable-type integrated unit, and may be attached to or detached from the gas supply pipes 232a to 232h and the like on an integrated unit basis, such that maintenance, replacement, ex tension, and the like of the integrated supply system 248 may be performed on an integr ated unit basis.

The exhaust port 231a configured to exhaust an internal atmosphere of the proces s chamber 201 is provided below the sidewall of the reaction tube 203. As illustrated in FIG. 2, in a plane view, the exhaust port 231a is positioned to oppose (face) the nozzles 2 49a to 249c (gas supply holes 250a to 250c) with the wafers 200 interposed therebetwee n. The exhaust port 231a may be provided from the lower side to the upper side of the si dewall of the reaction tube 203, that is, along the wafer arrangement region. An exhaust pipe 231 is connected to the exhaust port 231a. A vacuum pump 246 as a vacuum exhau ster is connected to the exhaust pipe 231 via a pressure sensor 245, which serves as a pre ssure detector (pressure detecting part) configured to detect an internal pressure of the process chamber 201, and an auto pressure controller (APC) valve 244, which serves as a pressure regulator (pressure regulating part). The APC valve 244 is configured to be c apable of performing or stopping a vacuum exhaust operation in the process chamber 2 01 by opening or closing the valve while the vacuum pump 246 is actuated, and is also c onfigured to be capable of regulating the internal pressure of the process chamber 201 b y adjusting an opening state of the valve based on pressure information detected by the pressure sensor 245 while the vacuum pump 246 is actuated. An exhaust system mainly includes the exhaust pipe 231, APC valve 244, and pressure sensor 245. The exhaust sys tem may include the vacuum pump 246.

A seal cap 219, which serves as a furnace opening lid configured to be capable of a irtightly sealing a lower end opening of the manifold 209, is provided under the manifol d 209. The seal cap 219 is made of, for example, metal material such as SUS, and is for med in a disc shape. An O-ring 220b, which serves as a seal making contact with the lo wer side of the manifold 209, is provided at an upper surface of the seal cap 219. A rotat or 267 configured to rotate a boat 217, which will be described later, is installed under th e seal cap 219. A rotary shaft 255 of the rotator 267 is connected to the boat 217 through the seal cap 219. The rotator 267 is configured to rotate the wafer 200 by rotating the bo at 217. The seal cap 219 is configured to be vertically raised or lowered by a boat elevato r 115, which serves as an elevator installed outside the reaction tube 203. The boat eleva tor 115 is constituted as a transport apparatus (transporter) configured to load or unload (transport) the wafer 200 into or out of the process chamber 201 by raising or lowering t he seal cap 219.

A shutter 219s, which serves as a furnace opening lid configured to be capable of airtightly sealing a lower end opening of the manifold 209 in a state where the seal cap 2 19 is lowered and the boat 217 is unloaded from the process chamber 201, is provided un der the manifold 209. The shutter 219s is made of, for example, metal material such as SUS, and is formed in a disc shape. An O-ring 220c, which serves as a seal making cont act with the lower end of the manifold 209, is provided at an upper surface of the shutte r 219s. The opening/closing operation (such as elevating and rotating operations) of the shutter 219s is controlled by a shutter opening/closing mechanism 115s.

The boat 217, which serves as a substrate support, is configured to support a plur ality of wafers 200, e.g., 25 to 200 wafers in such a state that the wafers 200 are arrange d at intervals in a horizontal posture and in multiple stages along a vertical direction wit h the centers of the wafers 200 aligned with one another. The boat 217 is made of, for ex ample, a heat-resistant material such as quartz or SiC. Heat insulating plates 218, which are made of, for example, a heat-resistant material such as quartz or SiC, are supported i n multiple stages at a lower side of the boat 217.

A temperature sensor 263 is installed as a temperature detector inside the reactio n tube 203. An internal temperature of the process chamber 201 falls within a desired t emperature distribution by regulating a state of supplying electric power to the heater 2 07 based on temperature information detected by the temperature sensor 263. The tem perature sensor 263 is provided along the inner wall of the reaction tube 203.

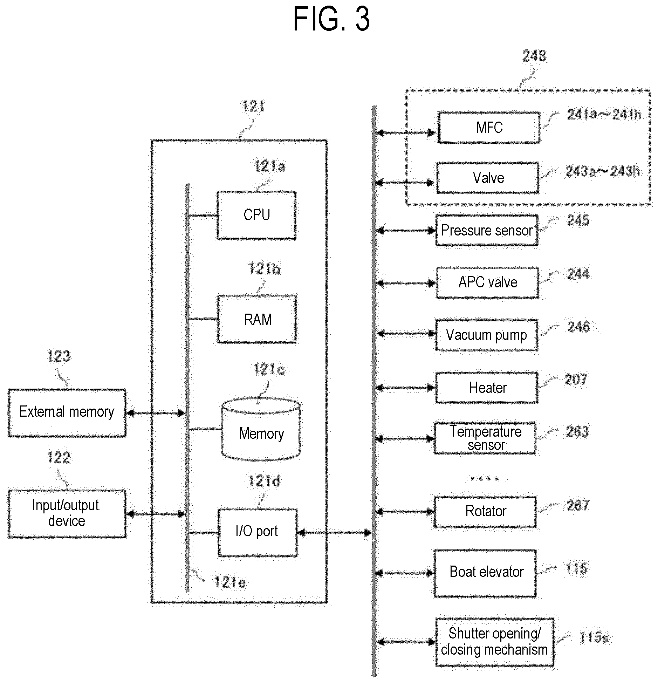

As illustrated in FIG. 3, the controller 121, which is a control part (control means or unit), is constituted as a computer including a central processing unit (CPU) 121a, a r andom access memory (RAM) 121b, a memory 121c, and an I/O port 121d. The RAM 121 b, the memory 121c, and the I/O port 121d are configured to be capable of exchanging da ta with the CPU 121a via an internal bus 121e. An input/output device 122 including, for example, a touch panel or the like, is connected to the controller 121. Further, an extern al memory 123 may be connected to the controller 121. In addition, the processing appa ratus may be configured to include one controller, or may be configured to include a plu rality of controllers. In other words, a control to perform a processing sequence to be de scribed later may be performed by using a single controller, or may be performed by usi ng a plurality of controllers. Further, the plurality of controllers may be constituted as a control system by being connected to each other through wired or wireless communicati on networks, and the control to perform the processing sequence to be described later m ay be performed by the entire control system. When the term "controller" is used herein , it may refer to one controller, a plurality of controllers, or a control system constituted by a plurality of controllers.

The memory 121c includes, for example, a flash memory, a hard disk drive (HDD) , a solid state drive (SSD), or the like. A control program that controls an operation of a processing apparatus, a process recipe in which sequences, conditions, and the like of pr ocessing to be described later are written, and the like are readably stored in the memor y 121c. The process recipe functions as a program that is combined to cause, by the cont roller 121, the processing apparatus (processing system) to perform each sequence in the processing to be described later, to obtain a predetermined result. Hereinafter, the proc ess recipe, the control program, and the like are generally and simply referred to as a "pr ogram." Further, the process recipe may be simply referred to as a "recipe." When the te rm "program" is used herein, it may refer to a case of including the recipe, a case of inclu ding the control program, or a case of including both the recipe and the control program . The RAM 121b is constituted as a memory area (work area) where programs, data, and the like read by the CPU 121a are temporarily stored.

The I/O port 121d is connected to the above-described MFCs 241a to 241h, valves 243a to 243h, pressure sensor 245, APC valve 244, vacuum pump 246, temperature sens or 263, heater 207, rotator 267, boat elevator 115, shutter opening/closing mechanism 11 5s, and the like.

The CPU 121a is configured to be capable of reading and executing the control pr ogram from the memory 121c and reading the recipe from the memory 121c in response to, e.g., an input of an operation command from the input/output device 122. The CPU 121a is configured to be capable of controlling the flow rate regulating operation of vario us substances (gases) by the MFCs 241a to 241h, the opening/closing operation of the va lves 243a to 243h, the pressure regulating operation performed by the APC valve 244 ba sed on the opening/closing operation of the APC valve 244 and the pressure sensor 245, the actuating and stopping operation of the vacuum pump 246, the temperature regulati ng operation performed by the heater 207 based on the temperature sensor 263, the ope ration of rotating the boat 217 and adjusting a rotational speed of the boat 217 with the r otator 267, the operation of moving the boat 217 up or down by the boat elevator 115, the opening/closing operation of the shutter 219s by the shutter opening/closing mechanis m 115s, and the like, according to contents of the read recipe.

The controller 121 may be configured by installing, in the computer, the above-de scribed program recorded and stored in the external memory 123. Examples of the exte rnal memory 123 may include a magnetic disk such as a HDD, an optical disc such as a C D, a magneto-optical disc such as a MO, a semiconductor memory such as a USB memor y or a SSD, and the like. The memory 121c and the external memory 123 are constituted as a computer-readable recording medium. Hereinafter, the memory 121c and the exter nal memory 123 may be generally and simply referred to as a "recording medium." Whe n the term "recording medium" is used herein, it may refer to a case of including the me mory 121c, a case of including the external memory 123, or a case of including both the memory 121c and the external memory 123. Further, the program may be provided to th e computer by using a communication means or unit such as the Internet or a dedicated line, instead of using the external memory 123.

### (2) Processing Step

As a process (a method) of manufacturing a semiconductor device by using the ab ove-described processing apparatus, an example of a method of processing a substrate ( a processing method), i.e., an example of a processing sequence of selectively forming a f ilm on a surface of a second base, among first and second bases on a surface of the wafer 200 as a substrate, will be described mainly with reference to FIGS. 4A to 4E. In the foll owing description, an operation of each component constituting the processing apparat us is controlled by the controller 121. In addition, the processing apparatus is also referr ed to as a substrate processing apparatus, a film formation processing apparatus, or a fil m-forming apparatus. Further, the processing method is also referred to as a method of processing a substrate, a film formation processing method, or a film-forming method.

In addition, the wafer 200 as a substrate includes a first base and a second base o n a surface thereof, as illustrated in FIG. 4A. In the following description, for convenien ce, a case where the first base is a silicon nitride film (SiN film) and the second base is a silicon film (Si film) will be described as a representative example.

A processing sequence of the embodiments of the present disclosure includes the following steps:
(a) forming a first film containing a first element and a second element on a surf ace of a first base by supplying a first film-forming agent to a wafer 200 including the fir st base and a second base (Step A);
(b) forming an inhibitor layer on the first film by supplying a modifying agent to the wafer 200 and causing at least a portion of molecular structures of molecules constit uting the modifying agent to be adsorbed on the first film (Step B); and
(c) forming a second film containing the first element and the second element on a surface of the second base by supplying a second film-forming agent to the wafer 200 with the inhibitor layer formed on the first film (Step C).

Hereinafter, a case where in Step A, a first precursor, a first oxidizing agent, and a first catalyst are supplied as the first film-forming agent to the wafer 200, and in Step C, a second precursor, a second oxidizing agent, and a second catalyst are supplied as th e second film-forming agent to the wafer 200 will be described. Specifically, a case wher e in Step A, a cycle which includes (a1) supplying the first precursor and the first catalyst to the wafer 200 (Step A1) and (a2) supplying the first oxidizing agent and the first catal yst to the wafer 200 (Step A2) is performed a predetermined number of times (m times, where m is an integer of 1 or 2 or more), and in Step C, a cycle which includes (c1) suppl ying the second precursor and the second catalyst to the wafer 200 (Step C1) and (c2) su pplying the second oxidizing agent and the second catalyst to the wafer 200 (Step C2) is performed a predetermined number of times (n times, where n is an integer of 1 or 2 or more) will be described.

In addition, in at least one selected from the group of Step A1 and Step A2, the su pply of the first catalyst may be omitted depending on a processing condition, and in at 1 east one selected from the group of Step C1 and Step C2, the supply of the second catalys t may also be omitted. For example, the supply of the first catalyst may be omitted in St ep A1, the supply of the first catalyst may be omitted in Step A2, and the supply of the fir st catalyst may be omitted in each of Step A1 and Step A2. For example, in this step, the first precursor and the first oxidizing agent may be used as the first film-forming agent. Further, for example, the supply of the second catalyst may be omitted in Step C1, the su pply of the second catalyst may be omitted in Step C2, and the supply of the second catal yst may be omitted in each of Step C1 and Step C2. For example, in this step, the second precursor and the second oxidizing agent may be used as the second film-forming agent.

In addition, in the following example, a case where the processing sequence furth er includes (d) removing the first film by supplying an etching agent to the wafer 200 aft er the formation of the second film on the surface of the second base (step D) will be des cribed. In addition, the processing performed in Step D is also simply referred to as an " etch-back."

Herein, for convenience, the above-described processing sequence may also be re presented as follows. The same notation is also used in the following description of mod ifications and other embodiments. (First Precursor + First Catalyst → First Oxidizing Agent + First Catalyst) × m → Modifying Agent → (Second Precursor + Second Catalyst → Second Oxidizing Agent + S econd Catalyst) × n → Etching Agent (Etch-Back)

When the term "wafer" is used in the present disclosure, it may refer to "a wafer i tself" or "a stacked body of a wafer and certain layers or films formed on a surface of the wafer." When the phrase "a surface of a wafer" is used in the present disclosure, it may r efer to "a surface of a wafer itself" or "a surface of a certain layer formed on a wafer." W hen the expression "a certain layer is formed on a wafer" is used in the present disclosur e, it may mean that "a certain layer is formed directly on a surface of a wafer itself" or th at "a certain layer is formed on a layer formed on a wafer." When the term "substrate" is used in the present disclosure, it may be synonymous with the term "wafer."

The term "layer" as used herein includes at least one selected from the group of a continuous layer and a discontinuous layer. For example, a first layer, a second layer, a third layer, a fourth layer, and an inhibitor layer may each include a continuous layer, a discontinuous layer, or both.

The term "agent" as used herein includes at least one selected from the group of g aseous substance and liquefied substance. The liquefied substance includes a mist-like s ubstance. In other words, each of the first film-forming agent (first precursor, first oxidi zing agent, and first catalyst), the second film-forming agent (second precursor, second oxidizing agent, and second catalyst), and the third film-forming agent (third precursor, third oxidizing agent, and third catalyst), the modifying agent, and the etching agent ma y include gaseous substance, liquefied substance such as mist-like substance, or both.

### (Wafer Charging and Boat Loading)

After the boat 217 is charged with a plurality of wafers 200 (wafer charging), the s hutter 219s is moved by the shutter opening/closing mechanism 115s and the lower end opening of the manifold 209 is opened (shutter opening). Thereafter, as shown in FIG. 1 , the boat 217 supporting the plurality of wafers 200 is lifted by the boat elevator 115 and loaded into the process chamber 201 (boat loading). In this state, the seal cap 219 seals the lower end of the manifold 209 via the O-ring 220b. Thus, the wafers 200 are provid ed inside the process chamber 201.

### (Pressure Regulation and Temperature Regulation)

After the boat loading is completed, the inside of the process chamber 201, that is , a space where the wafers 200 are placed, is vacuum-exhausted (decompression-exhaus ted) by the vacuum pump 246 to reach a desired pressure (state of vacuum). In this ope ration, the internal pressure of the process chamber 201 is measured by the pressure sen sor 245, and the APC valve 244 is feedback-controlled based on the measured pressure i nformation. Further, the wafers 200 in the process chamber 201 are heated by the heat er 207 to reach a desired processing temperature. In this operation, a state of supplying electric power to the heater 207 is feedback-controlled based on the temperature inform ation detected by the temperature sensor 263 such that a temperature distribution in th e process chamber 201 becomes a desired temperature distribution. Further, the rotatio n of the wafers 200 by the rotator 267 is started. The exhaust of the inside of the proces s chamber 201 and the heating and rotation of the wafers 200 are continuously perform ed at least until the processing on the wafers 200 is completed.

### (Step A)

Thereafter, by supplying a first film-forming agent to the wafer 200 including a fi rst base and a second base on a surface thereof, a first film containing a first element an d a second element is formed on a surface of the first base. In this step, specifically, the following Steps A1 and A2 are sequentially executed.

### [Step A1]

In this step, a first precursor and a first catalyst are supplied to the wafer 200.

Specifically, the valves 243a and 243b are opened to cause the first precursor and the first catalyst to flow through the gas supply pipes 232a and 232b, respectively. The f irst precursor and the first catalyst are regulated in flow rate by the MFCs 241a and 241b , respectively, and are supplied into the process chamber 201 via the nozzles 249a and 2 49b, respectively. The first precursor and the first catalyst are mixed inside the process chamber 201, and then are exhausted via the exhaust port 231a. At this time, the first pr ecursor and the first catalyst are supplied to the wafer 200 from a lateral side of the wafe r 200 (supply of first precursor + first catalyst). At this time, the valves 243e to 243g ma y be opened to supply an inert gas into the process chamber 201 via the respective nozzl es 249a to 249c.

By supplying the first precursor and the first catalyst to the wafer 200 under a pr ocessing condition to be described later, it is possible to selectively (preferentially) chem isorb at least a portion of molecular structures of molecules constituting the first precurs or on the surface of the first base among the surfaces of the first base and the second bas e. This allows a first layer to be selectively formed on the surface of the first base. The fi rst layer contains at least a portion of molecular structures of molecules constituting the first precursor, which is a residue derived from the first precursor.

In this step, a property that an incubation time on the surface of the second base i s longer than an incubation time on the surface of the first base when forming the first la yer by using the first precursor, which is a first film-forming agent, is used to selectively form the first layer on the surface of the first base. A surface of a SiN film, which is the fi rst base, contains NH terminations or OH terminations, while a surface of a Si film, whi ch is the second base, contains H terminations. When forming the first layer, an incubat ion time on the H terminations in the surface of the Si film is longer than an incubation t ime on the NH terminations or OH terminations in the surface of the SiN film. In other words, it is more difficult to form the first layer on the surface of the Si film, which conta ins H terminations, than on the surface of the SiN film, which contains NH terminations or OH terminations. Therefore, in this step, it is possible to selectively (preferentially) f orm the first layer on the surface of the SiN film, which is the first base, rather than on t he surface of the Si film, which is the second base. In addition, in this regard, it may be said that when attempting to form the first layer on the surface containing NH terminati ons, OH terminations, or H terminations, the H terminations or the surface containing t he H terminations may cause a film formation inhibition effect (an adsorption inhibition effect or a reaction inhibition effect).

In addition, to reliably expose the H terminations on the surface of the Si film, wh ich is the second base, the surface of the wafer 200 may be previously exposed to an etch ing agent such as an aqueous HF solution (DHF). A native oxide film may be formed on the surface of the Si film, which is the second base. In this case, by exposing the surface of the wafer 200 to the etching agent, the native oxide film on the surface of the Si film may be removed, thereby reliably exposing the H terminations on the surface of the Si fil m. In addition, a native oxide film may be formed on the surface of the SiN film, which i s the first base. In this case, by exposing the surface of the wafer 200 to the etching age nt, the native oxide film on the surface of the SiN film may also be removed, thereby allo wing the NH terminations or OH terminations to be appropriately exposed on the surfac e of the SiN film. In addition, the etching agent may be the same as an etching agent use d in Step D to be described later, and an etching process at this time may be carried out with the same processing sequence and processing condition as the etching processing i n Step D to be described later.

A processing condition when the first precursor and the first catalyst are supplied in this step is exemplified as follows:
Processing temperature: room temperature (25 degrees C) to 200 degrees C, spe cifically 25 to 150 degrees C;
Processing pressure: 13 to 2,666 Pa, specifically 13 to 1,333 Pa;
Processing time: 1 to 90 seconds, specifically 1 to 60 seconds;
Supply flow rate of first precursor: 0.001 to 2 slm, specifically 0.001 to 1 slm;
Supply flow rate of first catalyst: 0.001 to 2 slm, specifically 0.001 to 1 slm; and
Supply flow rate of Inert gas (for each gas supply pipe): 0 to 20 slm.

In addition, notation of a numerical range such as "25 to 200 degrees C" herein m eans that lower and upper limit values are included in that range. Therefore, for exampl e, "25 to 200 degrees C" means "25 degrees C or more and 200 degrees C or less." The s ame applies to other numerical ranges. Further, the processing temperature herein mea ns the temperature of the wafer 200 or the internal temperature of the process chamber 201, and the processing pressure herein means the internal pressure of the process cha mber 201. Further, the processing time means a time during which a process is continu ed. Further, when 0 slm (sccm) is included in the supply flow rate, 0 slm (sccm) means a case where no gas is supplied. The same applies to the following description.

After the first layer is selectively formed on the surface of the first base, the valves 243a and 243b are closed to stop the supply of the first precursor and the first catalyst in to the process chamber 201. Then, the interior of the process chamber 201 is vacuum-ex hausted to remove gaseous substance and the like remaining in the process chamber 20 1 from the interior of the process chamber 201. At this time, the valves 243e to 243g are opened to supply an inert gas into the process chamber 201 via the nozzles 249a to 249c. The inert gas supplied from the nozzles 249a to 249c acts as a purge gas, thereby purgin g the interior of the process chamber 201 (purging).

A processing condition when the purging is performed in this step is exemplified as follows:
Processing pressure: 1 to 30 Pa;
Processing time: 1 to 120 seconds, specifically 1 to 60 seconds; and
Supply flow rate of inert gas (for each gas supply pipe): 0.5 to 20 slm

Further, the processing temperature during the purging may be the same as the p rocessing temperature during the supply of the first precursor and the first catalyst.

As the first precursor, for example, a substance (gas) containing at least one selec ted from the group of an amino group, an alkoxy group, and a chloro group may be used . Further, the substance (gas) containing at least one selected from the group of an amin o group, an alkoxy group, and a chloro group may be a substance (gas) containing silico n (Si). The first precursor may be selected depending on a type of the first base. For exa mple, in a case where the first base is a film composed of a metal element, a substance (g as) containing an amino group and Si may be selected.

For example, a substance (gas) containing an amino group and Si such as tetrakis (dimethylamino)silane (Si[N(CH₃)₂]₄), tris(dimethylamino)silane (Si[N(CH₃)₂]₃H), bis( diethylamino)silane (Si[N(C₂H₅)₂]₂H₂), bis(tert-butylamino)silane (SiH₂[NH(C₄H₉)]₂), a nd (diisopropylamino)silane (SiH₃[N(C₃H₇)₂]) may also be used as the first precursor.

Further, a substance (gas) containing an alkoxy group and Si such as tetramethox ysilane (Si(OCH₃)₄) and tetraethoxysilane (Si(OC₂H₅)₄) may be used as the first precurs or. Further, for example, a substance (gas) containing an alkoxy group, an amino group, and Si such as (dimethylamino)trimethoxysilane ((CH₃)₂NSi(OCH₃)₃) and (dimethylami no)triethoxysilane ((CH₃)₂N]Si(OC₂H₅)₃) may also be used as the first precursor. One or more of these may be used as the first precursor.

Further, for example, a substance (gas) containing a chloro group and Si such as bis(trichlorosilyl)methane ((SiCl₃)₂CH₂), 1,2-bis(trichlorosilyl)ethane ((SiCl₃)₂C₂H₄), 1,1, 2,2-tetrachloro-1,2-dimethyldisilane ((CH₃)₂Si₂Cl₄), 1,2-dichloro-1,1,2,2-tetramethyldis ilane ((CH₃)₄Si₂Cl₂), 1,1,3,3-tetrachloro-1,3-disilacyclobutane (C₂H₄Cl₄Si₂) maybe used as the first precursor. These substances also contain an alkylene group or an alkyl group . Further, for example, a substance (gas) containing a chloro group and Si such as tetrac hlorosilane (SiCl₄), hexachlorodisilane (Si₂Cl₆), and octachlorotrisilane (Si₃Cl₈) may be u sed as the first precursor. Further, for example, a substance (gas) containing a chloro gr oup and Si such as hexachlorodisiloxane (Cl₃Si-O-SiCl₃) and octachlorotrisiloxane (Cl₃Si -O-SiCl₂-O-SiCl₃) may be used as the first precursor. These substances also contain oxy gen. One or more of these may be used as the first precursor.

As the first catalyst, for example, an amine-based substance (amine-based gas) co ntaining carbon (C), nitrogen (N), and hydrogen (H) may be used. A cyclic amine-based substance (cyclic amine-based gas) or a chain-shaped amine-based substance (chain-sh aped amine-based gas) may be used as the amine-based substance. As the first catalyst, for example, a cyclic amine-based substance (cyclic amine-based gas) such as pyridine ( C₅H₅N), aminopyridine (C₅H₆N₂), picoline (C₆H₇N), rutidine (C₇H₉N), pyrimidine (C₄H₄ N₂), quinoline (C₉H₇N), piperazine (C₄H₁₀N₂), piperidine (C₅H₁₁N), pyrrolidine(C₄H₉N), and aniline(C₆H₇N) may be used. Further, for example, a chain-shaped amine-based su bstance (chain-shaped amine-based gas) such as triethylamine ((C₂H₅)₃N), diethylamin e ((C₂H₅)₂NH), monoethylamine ((C₂H₅)NH₂), trimethylamine ((CH₃)₃N), dimethylami ne ((CH₃)₂NH), and monomethylamine ((CH₃)NH₂) may be used as the first catalyst. O ne or more of these may be used as the first catalyst.

As the inert gas, for example, a noble gas such as nitrogen (N₂) gas, argon (Ar) ga s, helium (He) gas, neon (Ne) gas, and xenon (Xe) gas may be used. One or more of thes e may be used as the inert gas. The same applies each step to be described later.

### [Step A2]

After Step A1 is completed, a first oxidizing agent and the first catalyst are suppli ed to the wafer 200.

Specifically, the valves 243c and 243b are opened to cause the first oxidizing agen t and the first catalyst to flow through the gas supply pipes 232c and 232b, respectively. The first oxidizing agent and the first catalyst are regulated in flow rate by the MFCs 241 c and 241b, respectively, and are supplied into the process chamber 201 via the nozzles 2 49c and 249b, respectively. The first oxidizing agent and the first catalyst are mixed insi de the process chamber 201, and then are exhausted via the exhaust port 231a. At this ti me, the first oxidizing agent and the first catalyst are supplied to the wafer 200 from the lateral side of the wafer 200 (supply of first oxidizing agent + first catalyst). At this time , the valves 243e to 243g may be opened to supply an inert gas into the process chamber 201 via the nozzles 249a to 249c, respectively.

By supplying the first oxidizing agent and the first catalyst to the wafer 200 under a processing condition to be described later, it is possible to oxidize at least a portion of t he first layer formed on the surface of the first base in Step A1. Thus, a second layer for med by oxidizing the first layer is formed on the surface of the first base.

A processing condition when the first oxidizing agent and the first catalyst are su pplied in this step is exemplified as follows:
Processing temperature: room temperature (25 degrees C) to 200 degrees C, spe cifically 25 to 150 degrees C;
Processing pressure: 13 to 2666 Pa, specifically 13 to 1,333 Pa;
Processing time: 1 to 90 seconds, specifically 1 to 60 seconds;
Supply flow rate of first oxidizing agent: 0.001 to 2 slm, specifically 0.001 to 1 sl m;
Supply flow rate of first catalyst: 0.001 to 2 slm, specifically 0.001 to 1 slm; and
Supply flow rate of inert gas (for each gas supply pipe): 0 to 20 slm.

After oxidizing the first layer formed on the surface of the first base to change (tra nsform) the same into the second layer, the valves 243c and 243b are closed to stop the supply of the first oxidizing agent and the first catalyst into the process chamber 201, res pectively. Then, a gaseous substance and the like remaining in the process chamber 201 are removed from the interior of the process chamber 201 by using the same processing sequence and processing condition as in the purging in Step A1 (purging). In addition, t he processing temperature during the purging may be the same as the processing tempe rature during the supply of the first oxidizing agent and the first catalyst.

As the first oxidizing agent, for example, a substance containing oxygen (O) and h ydrogen (H) (O- and H-containing gas) may be used. For example, an O- and H-contain ing substance (O- and H-containing gas) such as water vapor (H₂O), hydrogen peroxide (H₂O₂), hydrogen (H₂) + oxygen (O₂), and H₂ + ozone (O₃) may be used as the first oxidi zing agent. In other words, O-containing substance + H-containing substance may be u sed as the O- and H-containing substance. In this case, instead of H₂, deuterium (D₂) m ay be used as the H-containing substance. One or more of these may be used as the first oxidizing agent.

In addition, notation of two substances such as "H₂ + O₂" herein means a mixed s ubstance (mixed gas) of H₂ and O₂. When supplying the mixed substance (mixed gas), t wo substances may be mixed (pre-mixed) in a supply pipe and then may be supplied int o the process chamber 201. Alternatively, the two substances may be separately supplie d into the process chamber 201 from different supply pipes and then may be mixed (pos t-mixed) inside the process chamber 201.

As the first catalyst, for example, catalysts similar to the various first catalysts exe mplified in Step A1 described above may be used.

### [Predetermined Number of Repetitions]

A cycle which includes Step A1 and Step A2 described above, specifically, a cycle which includes non-simultaneously (alternately) performing Step A1 and Step A2 is perf ormed a predetermined number of times (m times, where m is an integer of 1 or 2 or mo re). Thus, as illustrated in FIG. 4B, a first film containing a first element and a second el ement may be selectively formed on the surface of the first base, among the surfaces of t he first base and the second base of the wafer 200. For example, when the above-descri bed first precursor, first oxidizing agent, and first catalyst are used, an oxide film such as a silicon oxide film (SiO film), a silicon oxycarbide film (SiOC film), or a silicon oxycarbo nitride film (SiOCN film) may be selectively grown on the surface of the first base. In thi s manner, it is possible to selectively grow the first film, where, for example, the first ele ment is silicon (Si) and the second element is oxygen (O), on the surface of the first base . The first film may also contain carbon (C) or nitrogen (N).

Further, the above-described cycle may be performed multiple times. In other w ords, a thickness of the second layer formed per cycle may be set to be thinner than a de sired thickness of the first film and the above-described cycle may be performed multipl e times until the thickness of the first film formed by stacking the second layer reaches t he desired thickness.

In addition, when performing Step A1 and Step A2, there is a case where formatio n or growth of the first film occurs very minimally on the surface of the second base. Ho wever, in this case as well, the thickness of the first film formed on the surface of the sec ond base is significantly thinner than the thickness of the first film formed on the surfac e of the first base. Herein, the expression "selectively (preferentially) forming the first fi lm on the surface of the first base" includes a case where the first film is formed on the s urface of the first base without being formed on the surface of the second base, and a cas e where a very thin first film is formed on the surface of the second base while a first fil m much thicker than the first film formed on the surface of the second base is formed on the surface of the first base.

In this step, the thickness of the first film formed on the surface of the first base may be 0.5 nm or more and 10 nm or less, specifically 1 nm or more and 5 nm or less, an d more specifically 1.5 nm or more and 3 nm or less.

In a case where the thickness of the first film is less than 0.5 nm, an amount of at least a portion of molecular structures of molecules (residues derived from the modifyin g agent) constituting the modifying agent adsorbed on the surface of the first film may b e insufficient in Step B to be described later. In this case, an adsorption inhibition effect by an inhibitor layer formed on the surface of the first film may become insufficient. Su ch an issue may be resolved by setting the thickness of the first film to be 0.5 nm or mor e. The issue may be effectively resolved by making the thickness of the first film at 1 nm or more. The issue may be more effectively resolved by making the thickness of the first film at 1.5 nm or more.

In a case where the thickness of the first film is thicker than 10 nm, an adsorption inhibition effect on at least a portion of H terminations on the surface of the second base may be invalidated by an action of the first film-forming agent, resulting in an insufficie nt adsorption inhibition effect by the H terminations. Thus, the first film may also be fo rmed on the surface of the second base, and an inhibitor layer may also be formed on th e surface of the second base in the subsequent Step B. Such an issue may be resolved by setting the thickness of the first film to be 10 nm or less. The issue may be effectively res olved by setting the thickness of the first film to be 5 nm or less. The issue may be more effectively resolved by setting the thickness of the first film to be 3 nm or less.

The thickness of the first film formed in this step may be the same as or different from a thickness of a second film formed in Step C to be described later. In addition, in this step, specifically, the thickness of the first film may be less than or equal to the thick ness of the second film formed in Step C to be described later, and more specifically, the thickness of the first film may be less than the thickness of the second film formed in Ste p C. In other words, in this step, specifically, the thickness of the first film may be differ ent from the thickness of the second film formed in Step C, and more specifically, the thi ckness of the first film may be less than the thickness of the second film. Thus, it is poss ible to increase a difference in film thickness between the first film formed on the surfac e of the first base and the second film formed on the surface of the second base (i.e., thic kness of the second film - thickness of the first film), thereby enhancing a selectivity. Fu rther, a ratio of the thickness of the second film formed on the surface of the second bas e to the thickness of the first film formed on the surface of the first base may be increase d to enhance the selectivity.

Further, in a case where the first film is too thick, in this step, it may lead to desor ption of H terminations from the surface of the second base or substitutions of H termin ations with other terminations. This may result in formation of an inhibitor layer on the surface of the first film and the surface of the second base in Step B, which may hinder t he growth of the second film on the surface of the second base in Step C. In this regard, the thickness of the first film formed in this step may be set to be less than the thickness of the second film formed in Step C.

Further, in this step, by setting a film formation condition for the first film to be a condition where a reaction occurs gently, that is, a condition with low reactivity or reacti on intensity, H terminations may remain on the surface of the second base. In this step, in a case where the film formation condition for the first film is set to be a condition wit h high reactivity or reaction intensity, it may lead to desorption of H terminations from t he surface of the second base or substitutions of H terminations with other terminations . This may result in formation of an inhibitor layer on the surface of the first film and on the surface of the second base in Step B, which may hinder the growth of the second film on the surface of the second base in Step C. In this regard, in this step, the film formatio n condition for the first film may be set to be a condition where a reaction occurs gently.

Specifically, for example, by performing this step under at least one of the followi ng processing conditions, it is possible to set the film formation condition in this step m ay to be a condition where a reaction occurs gently, thereby allowing H terminations to r emain on the surface of the second base. Further, by adopting at least one of the followi ng processing conditions, this step is performed under a processing condition with a low er film formation rate than Step C to be described later.

A processing temperature in Step A (Step A1 and Step A2) is set to be higher than a processing temperature in Step C (Step C1 and Step C2).

A processing pressure in Step A (Step A1 and Step A2) is set to be lower than a pr ocessing pressure in Step C (Step C1 and Step C2).

A supply flow rate of first precursor in Step A1 is set to be smaller than a supply fl ow rate of second precursor in Step C1.

A supply flow rate of first oxidizing agent in Step A2 is set to be smaller than a su pply flow rate of second oxidizing agent in Step C2.

A supply time of first precursor in Step A1 is set to be shorter than a supply time 0 f second precursor in Step C1.

A supply time of first oxidizing agent in Step A2 is set to be shorter than a supply time of second oxidizing agent in Step C2.

### (Step B)

Thereafter, an inhibitor layer is formed on the first film through adsorption of at l east a portion of molecular structures of molecules constituting a modifying agent on a s urface of the first film formed on the surface of the first base by supplying the modifying agent to the wafer 200.

Specifically, the valve 243d is opened to cause the modifying agent to flow throug h the gas supply pipe 232d. The modifying agent is regulated in flow rate by the MFC 24 1d, is supplied into the process chamber 201 via the nozzle 249a, and is exhausted via th e exhaust port 231a. At this time, the modifying agent is supplied to the wafer 200 from the lateral side of the wafer 200 (supply of modifying agent). At this time, the valves 24 3e to 243g may be opened to supply an inert gas into the process chamber 201 through t he nozzles 249a to 249c respectively.

By supplying the modifying agent to the wafer 200 under a processing condition t o be described later, it is possible to cause at least a portion of molecular structures of m olecules constituting the modifying agent to be selectively (preferentially) adsorbed on t he surface of the first film among the surfaces of the first film and the second base. Thu s, as illustrated in FIG. 4C, an inhibitor layer is selectively formed on the surface of the fi rst film formed on the surface of the first base. In other words, in this step, it is possible to modify the surface of the first film by supplying the modifying agent to the wafer 200 such that at least a portion of molecular structures of molecules constituting the modifyi ng agent is selectively adsorbed on the surface of the first film to form the inhibitor layer

In this step, a property that an incubation time on the surface of the second base i s longer than an incubation time on the surface of the first film when the inhibitor layer is formed by using the modifying agent is used to selectively form the inhibitor layer on t he surface of the first film. As described above, in Step A, an oxide film such as a SiO fil m, SiOC film, or SiOCN film is formed as the first film on the surface of the first base. A surface of this oxide film contains OH terminations, and a surface of a Si film, which is t he second base, contains H terminations. When the inhibitor layer is formed, the incub ation time on the H terminations on the surface of the Si film is longer than the incubati on time on the OH terminations on the surface of the oxide film. In other words, it is m ore difficult to form the inhibitor layer on the surface of the Si film, which contains H ter minations, than on the surface of the oxide film, which contains OH terminations. Ther efore, in this step, it is possible to selectively (preferentially) form the inhibitor layer on the surface of the oxide film, which is the first film, rather than on the surface of the Si fi lm, which is the second base. In addition, in this regard, it may be said that when attem pting to form the inhibitor layer on a surface containing OH terminations or H terminati ons, the H terminations or the surface containing the H terminations may cause a film f ormation inhibition effect (an adsorption inhibition effect or a reaction inhibition effect)

The inhibitor layer formed in this step contains at least a portion of molecular str uctures of molecules constituting the modifying agent, which is a residue derived from t he modifying agent. The inhibitor layer prevents adsorption of a second film-forming ag ent (second precursor) on the surface of the first film in Step C to be described later, the reby inhibiting (preventing) progress of a film formation reaction on the surface of the fi rst film. In this regard, the inhibitor layer is also referred to as a film formation inhibiti on layer (an adsorption inhibition layer or a reaction inhibition layer).

As at least a portion of molecular structures of molecules constituting the modifyi ng agent, for example, a trialkylsilyl group such as a trimethylsilyl group (-SiMe₃), a trie thylsilyl group (-SiEt₃), or the like may be exemplified. In these cases, the surface of the first film is terminated by an alkyl group such as a methyl group or ethyl group. The alk yl group (alkylsilyl group) such as a methyl group (trimethylsilyl group) or ethyl group (t riethylsilyl group), which terminates the surface of the first film, constitutes the inhibito r layer, which may prevent adsorption of a second film-forming agent (second precursor ) on the surface of the first film in Step C to be described later, thereby inhibiting (preve nting) progress of a film formation reaction on the surface of the first film.

In addition, the term "inhibitor" as used herein may refer to the modifying agent or a residue derived from the modifying agent, for example, at least a portion of molecul ar structures of molecules constituting the modifying agent, as well as a film formation i nhibition effect (an adsorption inhibition effect or a reaction inhibition effect), and may also be used as a collective term for the entirety of these.

A processing condition when the modifying agent is supplied in this step is exem plified as follows:
Processing temperature: room temperature (25 degrees C) to 500 degrees C, spe cifically, 25 to 250 degrees C;
Processing pressure: 5 to 2000 Pa, specifically, 10 to 1000 Pa;
Processing time: 1 second to 120 minutes, specifically 30 seconds to 60 minutes;
Supply flow rate of modifying agent: 0.001 to 3 slm, specifically 0.001 to 0.5 slm; and
Supply flow rate of inert gas (for each gas supply pipe): 0 to 20 slm.

After the inhibitor layer is formed on the surface of the first film, the valve 243d i s closed to stop the supply of the modifying agent into the process chamber 201. Then, a residual gaseous substance and the like in the process chamber 201 are excluded from th e interior of the process chamber 201 under the same processing sequence and processi ng condition as in the purging in Step A1 (purging). In addition, the processing tempera ture during the purging may be the same as the processing temperature during the supp ly of the modifying agent.

As the modifying agent, for example, (dimethylamino)trimethylsilane ((CH₃)₂NSi (CH₃)₃), (diethylamino)triethylsilane ((C₂H₅)₂NSi(C₂H₅)₃), (dimethylamino)triethylsilan e ((CH₃)₂NSi(C₂H₅)₃), (diethylamino)trimethylsilane ((C₂H₅)₂NSi(CH₃)₃), (dipropylami no)trimethylsilane ((C₃H₇)₂NSi(CH₃)₃), (dibutylamino)trimethylsilane ((C₄H₉)₂NSi(CH ₃)₃), (trimethylsilyl)amine ((CH₃)₃SiNH₂), (triethylsilyl)amine ((C₂H₅)₃SiNH₂), (dimethy lamino)silane ((CH₃)₂NSiH₃), (diethylamino)silane ((C₂H₅)₂NSiH₃), (dipropylamino)sil ane ((C₃H₇)₂NSiH₃), (dibutylamino)silane ((C₄H₉)₂NSiH₃) or the like may be used. One or more of these may be used as the modifying agent.

Further, for example, bis(dimethylamino)dimethylsilane ([(CH₃)₂N]₂Si(CH₃)₂), bis(diethylamino)diethylsilane ([(C₂H₅)₂N]₂Si(C₂H₅)₂), bis(dimethylamino)diethylsilan e ([(CH₃)₂N]₂Si(C₂H₅)₂), bis(diethylamino)dimethylsilane ([(C₂H₅)₂N]₂Si(CH₃)₂), bis( dimethylamino))silane ([(CH₃)₂N]₂SiH₂), bis(diethylamino)silane ([(C₂H₅)₂N]₂SiH₂), b is(dimethylaminodimethylsilyl)ethane ([(CH₃)₂N(CH₃)₂Si]₂C₂H6) , bis(dipropylamino) silane ([(C₃H₇)₂N]₂SiH₂), bis(dibutylamino)silane ([(C₄H₉)₂N]₂SiH₂), bis(dipropylamin o)dimethylsilane ([(C₃H₇)₂N]₂Si(CH₃)₂), bis(dipropylamino)diethylsilane ([(C₃H₇)₂N]₂ Si(C₂H₅)₂), (dimethylsilyl)diamine ((CH₃)₂Si(NH₂)₂), (diethylsilyl)diamine ((C₂H₅)₂Si( NH₂)₂), (dipropylsilyl)diamine ((C₃H₇)₂Si(NH₂)₂), bis(dimethylaminodimethylsilyl)met hane ([(CH₃)₂N(CH₃)₂Si]₂CH₂), bis(dimethylamino)tetramethyldisilane ([(CH₃)₂N]₂(C H₃)₄Si₂) or the like may also be used as the modifying agent. One or more of these may be used as the modifying agent.

In addition at least a portion of molecular structures of molecules constituting th e modifying agent may be adsorbed on a portion of the surface of the second base when performing this step. However, even in this case, an amount of such an adsorption is sm all, and an amount of adsorption on the surface of the first film is overwhelmingly large. Herein, ""at least a portion of molecular structures of molecules constituting the modifyi ng agent are selectively (preferentially) adsorbed on the surface of the first film" include s a case where even at least a portion of molecular structures of molecules constituting t he modifying agent is not adsorbed on the surface of the second base, while at least a po rtion of molecular structures of molecules constituting the modifying agent is adsorbed on the surface of the first film, and a case where a very small amount of at least a portion of molecular structures of molecules constituting the modifying agent is adsorbed on the surface of the second base, while a much greater amount of at least a portion of molecul ar structures of molecules constituting the modifying agent is adsorbed on the surface of the first film than the surface of the second base.

### (Step C)

Thereafter, by supplying a second film-forming agent to the wafer 200 with the i nhibitor layer formed on the surface of the first film, a second film containing the first el ement and the second element is formed on the surface of the second base, as illustrated in FIG. 4D. In this step, specifically, the following Steps C1 and C2 are sequentially exec uted.

### [Step C1]

In this step, a second precursor and a second catalyst are supplied to the wafer 2 00. A processing sequence at this time may be the same as the processing sequence in S tep A1.

By supplying the second precursor and the second catalyst to the wafer 200 unde r a processing condition to be described later, at least a portion of molecular structure of molecules constituting the second precursor may be selectively (preferentially) chemisor bed on the surface of the second base among the surfaces of the inhibitor layer and the s econd base. This allows a third layer to be selectively formed on the surface of the secon d base. The third layer contains at least a portion of molecular structures of molecules c onstituting the second precursor, which is a residue derived from the second precursor.

In this step, a property that an incubation time on the surface of the inhibitor laye r is longer than an incubation time on the surface of the second base when forming the t hird layer by using the second precursor, which is a second film-forming agent, is used t o selectively form the third layer on the surface of the second base. As described above, the surface of the Si film, which is the second base, contains H terminations, and the sur face of the inhibitor layer contains alkyl group terminations. When the third layer is for med, an incubation time on the alkyl group terminations in the surface of the inhibitor l ayer is longer than an incubation time on the H terminations on the surface of the Si fil m. In other words, it is more difficult to form the third layer on the surface of the inhibit or layer, which contains alkyl group terminations, than on the surface of the Si film, whi ch contains H terminations. Therefore, in this step, it is possible to selectively (preferen tially) form the third layer on the surface of the Si film, which is the second base, rather t han on the surface of the inhibitor layer. In addition, in this regard, it may be said that when attempting to form the third layer on a surface containing H terminations or alkyl group terminations, the alkyl group terminations or the surface containing the alkyl gro up terminations may cause a film formation inhibition effect (an adsorption inhibition e ffect or a reaction inhibition effect).

A processing condition when the second precursor and the second catalyst are su pplied in this step is exemplified as follows:
Processing temperature: room temperature (25 degrees C) to 200 degrees C, spe cifically, 25 to 150 degrees C;
Processing pressure: 133 to 4,000 Pa, specifically, 133 to 2,666 Pa;
Processing time: 1 to 120 seconds, specifically, 1 to 90 seconds;
Supply flow rate of second precursor: 0.001 to 3 slm, specifically, 0.01 to 2 slm;
Supply flow rate of second catalyst: 0.001 to 3 slm, specifically, 0.01 to 2 slm; an d
Supply flow rate of inert gas (for each gas supply pipe): 0 to 20 slm.

After the third layer is formed on the surface of the second base, the supply of the second precursor and the second catalyst into the process chamber 201 is stopped. The n, a residual gaseous substance and the like in the process chamber 201 are removed fro m the interior of the process chamber 201 under the same processing sequence and proc essing condition as in the purging in Step A1 (purging). In addition, the processing tem perature during the purging may be the same as the processing temperature during the s upply of the second precursor and the second catalyst.

As the second precursor, for example, precursors similar to the various first precu rsors exemplified in Step A1 described above may be used. Although the second precurs or may be the same as or different from the first precursor used in Step A1, specifically, t he second precursor may be the same as the first precursor.

As the second catalyst, for example, catalysts similar to the various first catalysts exemplified in Step A1 described above may be used. Although the second catalyst may be the same as or different from the first catalyst used in Step A1, specifically, the second catalyst may be the same as the first catalyst.

### [Step C2]

After Step C1 is completed, a second oxidizing agent and the second catalyst are supplied to the wafer 200. The processing sequence at this time maybe the same as the processing sequence in Step A2.

By supplying the second oxidizing agent and the second catalyst to the wafer 200 under a processing condition to be described later, it is possible to oxidize at least a porti on of the third layer formed on the surface of the second base in Step C1. Thus, a fourth layer formed by oxidizing the third layer is formed on the surface of the second base.

A processing condition when the second oxidizing agent and the second catalyst a re supplied in this step is exemplified as follows:
Processing temperature: room temperature (25 degrees C) to 200 degrees C, spe cifically 25 to 150 degrees C;
Processing pressure: 133 to 4,000 Pa, specifically, 133 to 2,666 Pa;
Processing time: 1 to 120 seconds, specifically, 1 to 90 seconds;
Supply flow rate of second oxidizing agent: 0.001 to 3 slm, specifically, 0.01 to 2 slm;
Supply flow rate of second catalyst: 0.001 to 3 slm, specifically, 0.01 to 2 slm; an d
Supply flow rate of inert gas (for each gas supply pipe): 0 to 20 slm.

After the fourth layer is formed on the surface of the second base, the supply of th e second oxidizing agent and the second catalyst into the process chamber 201 is stoppe d. Then, a residual gaseous substance and the like in the process chamber 201 are remo ved from the interior of the process chamber 201 under the same processing sequence a nd processing condition as in the purging in Step A1 (purging). In addition, the processi ng temperature during the purging may be the same as the processing temperature duri ng the supply of the second oxidizing agent and the second catalyst.

As the second oxidizing agent, for example, oxidizing agents similar to the variou s first oxidizing agents exemplified in Step A2 described above may be used. Although t he second oxidizing agent may be the same as or different from the first oxidizing agent used in Step A2, specifically, the second oxidizing agent may be the same as the first oxi dizing agent.

As the second catalyst, for example, catalysts similar to the various first catalysts exemplified in Step A1 described above may be used. Although the second catalyst may be the same as or different from the first catalyst used in Step A1, specifically, the second catalyst may be the same as the first catalyst.

### [Performing Predetermined Number of Times]

A cycle which includes Step C1 and Step C2 described above, specifically, a cycle which includes non-simultaneously (alternately) performing Step C1 and Step C2 is perf ormed a predetermined number of times (n times, where n is an integer of 1 or 2 or mor e). Thus, as illustrated in FIG. 4D, a second film containing the first element and the sec ond element may be selectively formed on the surface of the second base, among the sur faces of the first base and the second base of the wafer 200. For example, when the abov e-described second precursor, second oxidizing agent, and second catalyst are used, an o xide film such as a SiO film, SiOC film, or SiOCN film may be selectively grown on the su rface of the second base. In this manner, it is possible to selectively grow the second fil m, where, for example, the first element is Si and the second element is O, on the surfac e of the second base. The first film may also contain C or N.

In addition, both the first film and the second film contain the first element and t he second element. The second film may be made of the same material as the first film. For example, in a case of the above-described example, both the first film and the secon d film may be SiO films, SiOC films, or SiOCN films. In addition, the second film may b e the same in composition ratio (constituent element ratio) as the first film. Further, the second film may be made of a different material from the first film. For example, in a ca se of the above-mentioned example, the first film may be a SiO film and the second film may be a SiOC film, or the first film may be a SiO film and the second film may be a SiO CN film.

Further, the above-described cycle may be performed multiple times. In other w ords, a thickness of the fourth layer formed per cycle may be set to be less than a desired thickness of the second film and the above-described cycle may be performed multiple ti mes until the thickness of the second film formed by stacking the fourth layer reaches th e desired thickness.

In addition, when Step C1 and Step C2 are performed, formation or growth of the second film may occur very minimally on the surface of the inhibitor layer. However, ev en in this case, the thickness of the second film formed on the surface of the inhibitor lay er is much less than the thickness of the second film formed on the surface of the second base. Herein, "selectively (preferentially) forming the second film on the surface of the s econd base" includes a case where the second film is not formed on the surface of the in hibitor layer and is formed on the surface of the second base, and a case where a very thi n second film is formed on the surface of the inhibitor layer while a second film much th icker than the second film formed on the surface of the inhibitor layer is formed on the s urface of the second base.

In this step, it is desirable to increase the thickness of the second film formed on t he surface of the second base, thereby enhancing a selectivity. The thickness of the seco nd film may be, for example, 0.5 nm or more and 15 nm or less. In addition, the second film formed in this step may be etched in the same manner as the first film in Step D to be described later. Therefore, the thickness of the second film in this step may be increa sed considering an amount of the second film to be etched in Step D.

### (Step D)

Thereafter, the first film is removed by supplying an etching agent to the wafer 2 00 after the second film is formed on the surface of the second base.

Specifically, the valve 243h is opened to cause the etching agent to flow through t he gas supply pipe 232h. The etching agent is regulated in flow rate by the MFC 241h, is supplied into the process chamber 201 via the nozzle 249a, and is exhausted via the exh aust port 231a. At this time, the etching agent is supplied to the wafer 200 from the late ral side of the wafer 200 (supply of etching agent). At this time, the valves 243e to 243g may be opened to supply an inert gas into the process chamber 201 via the nozzles 249a to 249c respectively.

By supplying the etching agent to the wafer 200 under a processing condition to be described later, the first film formed on the surface of the first base may be removed ( etched) to expose the surface of the first base. In addition, when the first film is remove d, the inhibitor layer remaining on the surface of the first film is also removed. Thus, th e surface of the first base of the wafer 200 is exposed as illustrated in FIG. 4E.

A processing condition during the supply of the etching agent in this step is exem plified as follows:
Processing temperature: room temperature (25 degrees C) to 400 degrees C, spe cifically, 50 to 200 degrees C;
Processing pressure: 1 to 13,332 Pa, specifically, 100 to 1,333 Pa;
Processing time: 0.1 to 60 minutes, specifically, 1 to 30 minutes;
Supply flow rate of etching agent: 0.05 to 5 slm, specifically, 0.1 to 2 slm; and
Supply flow rate of inert gas (for each gas supply pipe): 1 to 10 slm, specifically, 2 to 10 slm.

After the first film on the surface of the first base is removed, the valve 243h is clo sed to stop the supply of the etching agent into the process chamber 201. Then, a residu al gaseous substance and the like in the process chamber 201 are removed from the inte rior of the process chamber 201 under the same processing sequence and processing con dition as in the purging in Step A1 (purging). In addition, the processing temperature d uring the purging may be the same as the processing temperature during the supply of t he etching agent.

As the etching agent, for example, a fluorine (F)-containing substance (F-containi ng gas) may be used. For example, a F-containing substance (F-containing gas) such as chlorine trifluoride (ClF₃), chlorine fluoride (ClF), nitrogen fluoride (NF₃), fluorine (F₂), hydrogen fluoride (HF), and aqueous HF solution (DHF) may be used as the etching age nt. One or more of these may be used as the etching agent.

### (After-Purge and Returning to Atmospheric Pressure)

After Step D is completed, an inert gas serving as a purge gas is supplied into the process chamber 201 from each of the nozzles 249a to 249c, and is exhausted via the exh aust port 231a. Thus, the interior of the process chamber 201 is purged, and any gases, r eaction by-products, and the like remaining in the process chamber 201 are removed fro m the interior of the process chamber 201 (after-purge). Thereafter, the internal atmosp here of the process chamber 201 is replaced with the inert gas (inert gas replacement), a nd the internal pressure of the process chamber 201 is returned to the atmospheric pres sure (returning to atmospheric pressure).

### (Boat Unloading and Wafer Discharging)

Thereafter, the seal cap 219 is lowered by the boat elevator 115 to open the lower end of the manifold 209. Then, the processed wafers 200 supported by the boat 217 are unloaded from the lower end of the manifold 209 to the outside of the reaction tube 203 (boat unloading). After the boat is unloaded, the shutter 219s is moved, and the lower e nd opening of the manifold 209 is sealed by the shutter 219s via the O-ring 220c (shutte r closing). The processed wafers 200 are unloaded to the outside of the reaction tube 20 3 and are then discharged from the boat 217 (wafer discharging).

### (3) Effects of Embodiments of the present disclosure

According to the embodiments of the present disclosure, one or more of the follo wing effects are obtained.

By performing Step A, Step B, and Step C, it is possible to selectively form the sec ond film on the surface of the second base with high precision. This is because the incub ation time on the surface of the second base is longer than the incubation time on each 0 f the surfaces of the first base and the first film, and because the incubation time on the surface of the inhibitor layer is longer than the incubation time on the surface of the sec ond base. In other words, this is because the incubation time is the longest on the surfac e of the inhibitor layer, the second longest on the surface of the second base, and the sho rtest on each of the surfaces of the first base and the first film. In this manner, by contro lling the balance of the incubation time on the respective surfaces, it is possible to selecti vely form the first film on the surface of the first base in Step A, to selectively form the in hibitor layer on the surface of the first film in Step B, and to selectively form the second f ilm on the surface of the second base in Step C with high precision. In other words, acco rding to the embodiments of the present disclosure, it is possible to selectively form a de sired film on a desired surface with high precision.

By performing Step A, Step B, and Step C, a first film containing a first element a nd a second element is formed on the surface of a first base, an inhibitor layer is formed on the surface of the first film, and a second film containing the first element and the sec ond element is formed on the surface of a second base. For example, in a case where the first film contains a first element and a second element and the second film contains a t hird element and a fourth element, there is a possibility that the third element or the fou rth element may be mixed into the first film, or the first element or the second element may be mixed into the second film, that is, there is a possibility that cross-contaminatio n may occur, leading to deterioration in film characteristics. In contrast, when the first and second films each contain the same element, i.e., the first element and the second el ement, the above-described cross-contamination may be prevented and the film charact eristics may be improved. In particular, this effect becomes noticeable when the first fil m and the second film are formed in the same process chamber (in-situ).

Further, when the first and second films each contain the first element and the se cond element and an etch-back is performed on the first film by using an etching agent a fter the formation of the second film, i.e., when performing Step D after Step C, it is poss ible to control the film thickness of the second film, which may be exposed to the etchin g agent along with the first film, with high controllability. Further, when the first and se cond films each contain the first element and the second element, a supply system of a fi rst film-forming agent to form the first film and a supply system of a second film-formin g agent to form the second film may be shared, resulting in a simplified supply system. This significantly reduces an apparatus cost and simplifies an apparatus maintenance. Further, when the first and second films each contain the first element and the second el ement, a film formation temperature of the first film and a film formation temperature o f the second film may be made equal to each other. This may improve a throughout whe n repeating the processing of Step A, Step B, and Step C on different wafers 200, i.e., wh en performing continuous processing on different wafers 200, thereby improving a prod uctivity in continuous processing.

Further, specifically, the first film and the second film may be oxide films, more s pecifically, the first element may be Si and the second element may be O, and even more specifically, the first film may be a SiO film, SiOC film, or SiOCN film and the second fil m may be a SiO film, SiOC film, or SiOCN film. This enables the above-described effects to be effectively realized. In addition, materials (molecular structure, constituent eleme nts) of both the first film and the second film may be the same, such as a case where bot h the first film and the second film are SiO films. In this case, when performing Step D after Step C, the second film is etched in the same manner as the first film, such that the film thickness of the second film may be controlled with higher controllability. Further, materials of both the first film and the second film may be different, such as a case wher e both the first film is a SiO film and the second film is a SiOC film or SiOCN film. In thi s case, when the first film is a SiO film and the second film is a SiOC film or SiOCN film, and Step D is performed after performing Step C, the etching of the second film may be prevented due to an effect of the second film containing C or N, allowing a selective etchi ng of the first film. Thus, it is possible to control the film thickness of the second film, w hich may be exposed to the etching agent along with the first film during the etching of t he first film, with higher controllability.

Specifically, as a first film-forming agent, a first precursor and a first oxidizing ag ent may be supplied to the wafer 200 in Step A and, as a second film-forming agent, a se cond precursor and a second oxidizing agent may be supplied to the wafer 200 in Step C . Specifically, in Step A, a cycle which includes Step A1 of supplying the first precursor t o the wafer 200 and Step A2 of supplying the first oxidizing agent to the wafer 200 may be performed a predetermined number of times, and in Step C, a cycle which includes St ep C1 of supplying the second precursor to the wafer 200 and Step C2 of supplying the s econd oxidizing agent to the wafer 200 may be performed a predetermined number of ti mes. Further, a first catalyst may be supplied in at least one selected from the group of Step A1 and Step A2, and a second catalyst may be supplied in at least one selected from the group of Step C1 and Step C2. This enables the above-described effects to be effectiv ely realized. Further, an action of each catalyst may cause a processing temperature in e ach step to be lowered, thus causing a reaction occurring in each step to be milder, whic h may also improve the selectivity in the selective growth of the first and second films.

Specifically, the first precursor and the second precursor may be substances cont aining at least one selected from the group of an amino group, an alkoxy group, and a ch loro group, while the first oxidizing agent and the second oxidizing agent may be substa nces containing O and H. Further, the first precursor and the second precursor may be t he same substance or different substances. Further, the first oxidizing agent and the sec ond oxidizing agent may be the same substance or different substances. Further, more s pecifically, the first precursor and the second precursor may be the same substance and that the first oxidizing agent and the second oxidizing agent may be the same substance. Further, more specifically, when the first catalyst and the second catalyst are used, the fi rst precursor and the second precursor may be the same substance, the first oxidizing ag ent and the second oxidizing agent may be the same substance, and the first catalyst and the second catalyst may be the same substance. These may also be referred to as cases w here the first film-forming agent and the second film-forming agent are the same substa nce. This enables the above-described effects to be effectively realized.

Specifically, the thickness of the first film may be set to be less than or equal to th e thickness of the second film, or the thickness of the first film may be less than the thick ness of the second film. Further, specifically, Step A may be performed under a processi ng condition with a lower film formation rate than Step C. This allows a reaction during the formation of the first film to be milder than a reaction during the formation of the se cond film. Thus, a ratio of the thickness of the second film formed on the surface of the second base to the thickness of the first film formed on the surface of the first base may be increased, thereby enhancing the selectivity.

Specifically, the temperature of the wafer 200 may be the same during Step A, Ste p B, and Step C. In other words, specifically, the processing temperature may be the sa me in Step A, Step B, and Step C. This enables the above-described effect relating to the productivity to be effectively realized.

Further, specifically, Step A, Step B, and Step C may be performed within the sam e space. In other words, as described above, Step A, Step B, and Step C may be performe d in the same process chamber (in-situ). Thus, it is possible to continuously perform Ste p A, Step B, and Step C without transferring the wafer 200 among these steps. This mak es it possible to improve a throughput, leading to an improved productivity. Further, by performing Step A, Step B, and Step C within the same space (in the same process cham ber), it is possible to prevent the wafer 200 from being exposed to the atmosphere amon g these steps, thereby avoiding issues such as deterioration in selectivity due to atmosph ere exposure. This ensures proper selective growth. Further, in addition to Step A, Step B, and Step C, Step D may be performed within the same space (within the same process chamber) as Step A, Step B, and Step C, as described above.

### (4) Modifications

The processing sequence in the embodiments of the present disclosure may be c hanged as in the following modifications. These modifications may be combined arbitra rily. Unless otherwise specified, a processing sequence and a processing condition for e ach step in each modification may be the same as the processing sequence and the proce ssing condition for each step in the above-described processing sequence.

### (First Modification)

In a case where the first film formed on the surface of the first base may not be r emoved, Step D may be omitted as illustrated in the processing sequence below. In this modification as well, effects similar to those in the above-described embodiments are ob tained. (First Precursor + First Catalyst → First Oxidizing Agent + First Catalyst) × m → Modifying Agent → (Second Precursor + Second Catalyst → Second Oxidizing Agent + S econd Catalyst) × n

### (Second Modification)

(e) Step E of forming a third film on the second film may also be performed by s upplying a third film-forming agent to the wafer 200 after the formation of the second fi lm. Specifically, Step E may be performed after Step C and before Step D. In the followi ng example, a case where in Step E, a third precursor, a third oxidizing agent, and a thir d catalyst are supplied as the third film-forming agent to the wafer 200 will be described . In this case, specifically, in Step E, a cycle which includes (e1) supplying a third precur sor and a third catalyst to the wafer 200 (Step E1) and (e2) supplying a third oxidizing a gent and the third catalyst to the wafer 200 (Step E2) may be performed a predetermine d number of times (p times, where p is an integer of 1 or 2 or more), as illustrated in the processing sequence below. In addition, the supply of the third catalyst may be omitted in at least one selected from the group of Step E1 and Step E2. (First Precursor + First Catalyst → First Oxidizing Agent + First Catalyst) × m → Modifying Agent → (Second Precursor + Second Catalyst → Second Oxidizing Agent + S econd Catalyst) × n → (Third Precursor + Third Catalyst → Third Oxidizing Agent + Thi rd Catalyst) × p → Etching Agent (Etch-Back)

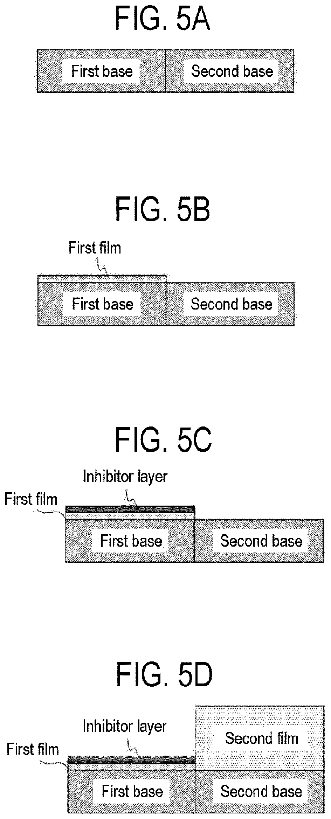

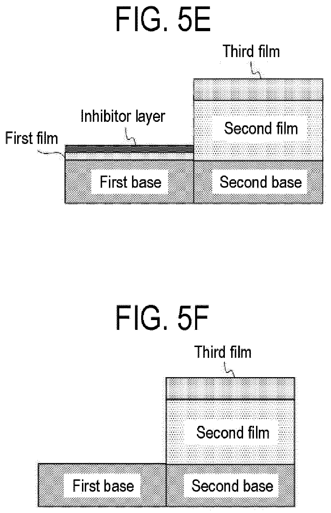

This modification will be described mainly with reference to FIGS. 5A to 5F. First , similar to the above-described embodiments, the wafer 200 including a first base and a second base on a surface thereof is used, as illustrated in FIG. 5A. Step A is performed b y using this wafer 200 to selectively form a first film on a surface of the first base, as illu strated in FIG. 5B. Thereafter, Step B is performed to form an inhibitor layer on a surfa ce of the first film, as illustrated in FIG. 5C. Thereafter, Step C is performed to selectivel y form a second film on a surface of the second base, as illustrated in FIG. 5D. Subseque ntly, Step E is performed to selectively form a third film on a surface of the second film, as illustrated in FIG. 5E. Thereafter, Step D is performed to remove the first film forme d on the surface of the first base along with the inhibitor layer, as illustrated in FIG. 5F. In this way, a stacked film constituted by the second film and the third film selectively st acked on the surface of the second base among the surfaces of the first and second bases of the wafer 200 is formed.

A processing sequence and a processing condition for Step E in this modification may be the same as the processing sequence and the processing condition for Step C in t he above-described processing sequence, except for using the third film-forming agent ( third precursor, third oxidizing agent, and third catalyst) and supplying the third film-fo rming agent to the wafer 200 after Step C. As the third precursor, for example, precurso rs similar to the various first precursors exemplified in Step A1 described above may be used. As the third oxidizing agent, for example, oxidizing agents similar to the various fi rst oxidizing agents exemplified in Step A2 described above may be used. As the third c atalyst, catalysts similar to the various first catalysts exemplified in Step A1 described ab ove may be used. Further, specifically, the third film-forming agent (third precursor, thi rd oxidizing agent, and third catalyst) may differ from the second film-forming agent (se cond precursor, second oxidizing agent, and second catalyst). Further, specifically, the t hird film may be made of a different material from the second film. Further, the third fil m may be made of a different material from the first film. For example, in a case where the first film is a SiO film and the second film is a SiO film, the third film may be a SiOC film or a SiOCN film. Further, for example, in a case where the first film is a SiO film an d the second film is a SiOC film, the third film may be a SiOC film or a SiOCN film.

Even in this modification, the same effects as in the above-described embodiment s are obtained. Further, in this modification, by forming the third film on the second fil m, the third film may act as an etching block film (cap film, etching barrier film, etching inhibitor film) when etching back the first film by using an etching agent after the forma tion of the second film. Therefore, specifically, the third film may be higher in etching r esistance than the second film. Further, specifically, the third film may be higher in etch ing resistance than the first film. For example, when the third film is a film containing C or N, such as a SiOC film or SiOCN film, an etching resistance of the third film may be e nhanced. This allows the selective etching of the first film without etching the second fil m, enabling the thickness of the second film to be controlled with high controllability ev en when etching back the first film.

### <Other Embodiments of Present Disclosure>

The embodiments of the present disclosure are specifically described above. Ho wever, the present disclosure is not limited to the above-described embodiments and ma y be changed in various ways without departing from the gist of the present disclosure.

For example, the wafer 200 may include multiple types of regions made of differe nt materials serving as the first base, and may include multiple types of regions made of different materials serving as the second base. In the wafer 200, any base that includes a surface (terminations) with a shorter incubation time during the formation of the first film than the second base may be used as the first base. That is, any base may be used a s the first base and the second base in the wafer 200 as long as the base includes at least two types of surfaces with different incubation times during the formation of the first fil m. For example, specifically, the first base may include an insulating film, the second ba se may include at least one selected from the group of a semiconductor substrate, a film composed of a semiconductor element, and a film composed of a metal element. Furthe r, specifically, the insulating film may include at least one selected from the group of a se miconductor insulating film and a metal insulating film. In these cases, it is possible to appropriately generate the above-described difference in incubation time on the respecti ve surfaces of the first base and the second base during the formation of the first film. I n the embodiments of the present disclosure as well, effects similar to those in the above -described embodiments are obtained.

The first base may be a semiconductor insulating film such as a SiO film (includin g a native oxide film), a SiOC film, a SiOCN film, a silicon oxynitride film (SiON film), a silicon carbide film (SiC film), a silicon carbonitride film (SiCN film), silicon boron nitri de film (SiBN film), silicon boron carbonitride film (SiBCN film), and other Si-based ins ulating films, in addition to the SiN film described above, or may be a metal insulating fi lm such as a hafnium oxide film (HfO film), a zirconium oxide film (ZrO film), an alumi num oxide film (AlO film), and other metal-based oxide film. At least one of these films may be used as the first base.

The second base may be a semiconductor substrate such as a Si wafer (single crys tal Si), in addition to the Si film described above. In addition, the Si film includes a film composed of a semiconductor element such as an amorphous silicon film (a-Si film), pol ysilicon film (poly-Si film), a mixed crystal film of an amorphous silicon and a polysilico n, and an epitaxial silicon film (Epi-Si film). Further, the second base may be a film com posed of a metal element such as a copper film (Cu film), a tungsten film (W film), a rut henium film (Ru film), a cobalt film (Co film), or a molybdenum film (Mo film). At least one of these films may be used as the second base.

Further, in the above-described embodiments, an example where the above-descr ibed processing sequence is performed in the same process chamber of the same process ing apparatus (in-situ) is described. The present disclosure is not limited to the above-d escribed embodiments, and for example, one step and another step of the above-describ ed processing sequence may be performed respectively in different process chambers of different processing apparatuses (ex-situ) or may be performed respectively in different process chambers of the same processing apparatus. In such cases as well, effects simila r to those in the above-described embodiments are obtained.

In the various cases described above, by performing a series of steps in-situ, the wafer 200 may not be exposed to the atmosphere during the processing, which allows th e wafer 200 to be processed consistently while keeping the wafer 200 under vacuum, th ereby enabling a stable processing of the wafer 200. Further, by performing some steps ex-situ, it is possible to set the temperature in each process chamber, for example, close to or at the processing temperature for each step in advance, thereby shortening a time which is taken to regulate the temperature. This enhances a throughput, thereby impro ving a productivity.

Specifically, the recipes used in each process may be provided individually accord ing to processing contents and may be record and stored in the memory 121c via a teleco mmunication line or the external memory 123. Further, specifically, at the beginning of each processing, the CPU 121a may properly select an appropriate recipe among a plural ity of recipes recorded and stored in the memory 121c according to the processing conte nts. Thus, it is possible to form films of various types, composition ratios, qualities, and thicknesses with enhanced reproducibility in a processing apparatus. Further, it is possi ble to reduce an operator's burden, and quickly start each processing while avoiding an operation error.

The recipes mentioned above are not limited to newly-provided ones but may be provided, for example, by modifying existing recipes that are already installed in the pro cessing apparatus. Once the recipes are modified, the modified recipes may be installed in the processing apparatus via a telecommunication line or a recording medium storing the recipes. In addition, the existing recipes already installed in the existing processing apparatus may be directly modified by operating the input/output device 122 of the proc essing apparatus.

An example in which a film is formed by using a batch-type processing apparatus configured to process a plurality of substrates at a time is described in the above-describ ed embodiments of the present disclosure. The present disclosure is not limited to the a bove-described embodiments of the present disclosure, but may be suitably applied, for example, to a case where a film is formed by using a single-wafer type processing appara tus configured to process a single substrate or several substrates at a time. In addition, an example in which a film is formed by using a processing apparatus including a hot-w all-type process furnace is described above in the above-described embodiments. The p resent disclosure is not limited to the above-described embodiments, but may be suitabl y applied to a case where a film is formed by using a processing apparatus including a co ld-wall-type process furnace.

Even in the case of using these processing apparatuses, each process may be perf ormed according to the same processing procedure and processing condition as those in the above-described embodiments and modifications, and the same effects as the above-described embodiments and modifications are achieved.

The above-described embodiments and modifications may be used in proper com bination. The processing procedure and processing condition used in this case may be t he same as, for example, those in the above-described embodiments and modifications.

According to the present disclosure in some embodiments, it is possible to selecti vely form a film on a desired surface with high precision.

While certain embodiments are described above, these embodiments are present ed by way of example, and are not intended to limit the scope of the disclosures. Indeed, the embodiments described herein may be embodied in a variety of other forms. Furthe rmore, various omissions, substitutions and changes in the form of the embodiments de scribed herein may be made without departing from the spirit of the disclosures. The ac companying claims and their equivalents are intended to cover such forms or modificati ons as would fall within the scope and spirit of the disclosures.

## Claims

1. A processing method comprising:
(a) forming a first film containing a first element and a second element on a surf ace of a first base by supplying a first film-forming agent to a substrate including the firs t base and a second base;
(b) forming an inhibitor layer on the first film by supplying a modifying agent to the substrate and causing at least a portion of molecular structures of molecules constitu ting the modifying agent to be adsorbed on the first film; and
(c) forming a second film containing the first element and the second element on a surface of the second base by supplying a second film-forming agent to the substrate w ith the inhibitor layer formed on the first film.

2. The processing method of Claim 1, wherein the first film is an oxide film and the s econd film is an oxide film.

3. The processing method of Claim 1, wherein the first element is silicon and the seco nd element is oxygen.

4. The processing method of Claim 3, wherein the first film is a silicon oxide film, a si licon oxycarbide film, or a silicon oxycarbonitride film, and the second film is a silicon o xide film, a silicon oxycarbide film, or a silicon oxycarbonitride film.

5. The processing method of Claim 1, wherein the first film and the second film are made of the same material.

6. The processing method of Claim 1, wherein in (a), a first precursor and a first oxidi zing agent are supplied as the first film-forming agent to the substrate, and
wherein in (c), a second precursor and a second oxidizing agent are supplied as t he second film-forming agent to the substrate.

7. The processing method of any one of Claims 1 to 5, wherein a thickness of the first film is less than or equal to a thickness of the second film.

8. The processing method of any one of Claims 1 to 5, wherein (a) is performed under a processing condition with a lower film formation rate than (c).

9. The processing method of any one of Claims 1 to 5, wherein a temperature of the s ubstrate is the same in (a), (b), and (c).

10. The processing method of any one of Claims 1 to 5, wherein (a), (b), and (c) are pe rformed in the same space.

11. The processing method of any one of Claims 1 to 5, further comprising (d) removi ng the first film by supplying an etching agent to the substrate after forming the second f ilm on the surface of the second base.

12. The processing method of any one of Claims 1 to 5, wherein the first base includes an insulating film, and the second base includes at least one selected from the group of a semiconductor substrate, a film composed of a semiconductor element, and a film comp osed of a metal element.

13. A method of manufacturing a semiconductor device, comprising the processing m ethod of Claim 1.

14. A processing apparatus comprising:
a first film-forming agent supply system configured to supply a first film-formin g agent to a substrate;
a modifying agent supply system configured to supply a modifying agent to the s ubstrate;
a second film-forming agent supply system configured to supply a second film-fo rming agent to the substrate; and
a controller configured to be capable of controlling the first film-forming agent s upply system, the modifying agent supply system, and the second film-forming agent su pply system to perform a process including:
(a) forming a first film containing a first element and a second element on a surf ace of a first base by supplying the first film-forming agent to the substrate including the first base and a second base;
(b) forming an inhibitor layer on the first film by supplying the modifying agent t o the substrate and causing at least a portion of molecular structures of molecules consti tuting the modifying agent to be adsorbed on the first film; and
(c) forming a second film containing the first element and the second element on a surface of the second base by supplying the second film-forming agent to the substrate with the inhibitor layer formed on the first film.

15. A program that causes, by a computer, a processing apparatus to perform a proces s comprising:
(a) forming a first film containing a first element and a second element on a surf ace of a first base by supplying a first film-forming agent to a substrate including the firs t base and a second base;
(b) forming an inhibitor layer on the first film by supplying a modifying agent to the substrate and causing at least a portion of molecular structures of molecules constitu ting the modifying agent to be adsorbed on the first film; and
(c) forming a second film containing the first element and the second element on a surface of the second base by supplying a second film-forming agent to the substrate w ith the inhibitor layer formed on the first film.
